Europäisches Patentamt

European Patent Office

Office européen des brevets

(19)

(11) **EP 1 260 091 B1**

(12) **FASCICULE DE BREVET EUROPEEN**

(45) Date de publication et mention
de la délivrance du brevet:
**02.11.2005 Bulletin 2005/44**

(21) Numéro de dépôt: **01911822.3**

(22) Date de dépôt: **02.03.2001**

(51) Int Cl.⁷: **H04M 11/06**, H03H 11/34

(86) Numéro de dépôt international:
**PCT/FR2001/000614**

(87) Numéro de publication internationale:
**WO 2001/065790 (07.09.2001 Gazette 2001/36)**

(54) **FILTRE A AIGUILLAGE POUR LIGNE DE TRANSMISSION D'INFORMATIONS**

ABZWEIGFILTER FÜR DATENÜBERTRAGUNGSSTRECKE

POWER SEPARATING FILTER FOR DATA TRANSMISSION LINE WITH COMPLEX IMPEDANCE

(84) Etats contractants désignés:
**AT BE CH CY DE DK ES FI FR GB GR IE IT LI LU
MC NL PT SE TR**

(30) Priorité: **03.03.2000 FR 0003081**

(43) Date de publication de la demande:
**27.11.2002 Bulletin 2002/48**

(73) Titulaire: **Laboratoire Europeen ADSL
37380 Crotelles (FR)**

(72) Inventeurs:
• **DEDIEU, Hervé
F-35500 Vitré (FR)**

• **BERTHAUD, Eric
F-37380 Reugny (FR)**

(74) Mandataire: **Thibon-Littaye, Annick
Cabinet THIBON-LITTAYE
11 rue de l'Etang,
BP 19
78164 Marly-le-Roi Cédex (FR)**

(56) Documents cités:
**EP-A- 0 677 938          US-A- 5 072 200**

EP 1 260 091 B1

**Description**

La présente invention concerne les systèmes de transmission d'informations comprenant des données numériques modulées et des signaux analogiques par les lignes téléphoniques, c'est-à-dire les systèmes qui permettent la transmission simultanée d'une conversation téléphonique, et de données sur une même ligne téléphonique ou boucle d'abonné. Il y a donc une transmission simultanée d'une conversation téléphonique et de données numériques modulées, par exemple en liaison avec un réseau Internet, entre un poste d'abonné et un central téléphonique. On connaît en particulier des systèmes de ce genre du type asymétrique (ADSL) dans lesquels le flux de données envoyées par l'abonné sur la ligne est à faible débit et occupe une bande de fréquences réduite et le flux de données entrant chez l'abonné est à haut débit et utilise une gamme de fréquence plus large qui est adjacente à la gamme de fréquences utilisée pour le flux à faible débit.

Pour réaliser, autant du côté de l'abonné que du côté du central téléphonique, la séparation entre la voie de données à haute fréquence et la voie de signaux analogiques téléphoniques à basse fréquence, on utilise un filtre à aiguillage. Ce filtre à aiguillage sépare, au niveau de l'abonné, les données numériques modulées à haute fréquence des signaux analogiques à basse fréquence, les données numériques modulées à haute fréquence étant envoyées, par exemple, à un modem, puis à un micro-ordinateur, et les signaux analogiques téléphoniques à basse fréquence étant envoyés sur l'appareil téléphonique de l'abonné.

L'art antérieur à la présente invention dans ce domaine est illustré par le document EP 0 677 938.

Les lignes téléphoniques classiques sont constituées de fils en cuivre comportant une gaine isolante en polyéthylène et torsadés. Une telle ligne présente une impédance complexe comportant un terme capacitif correspondant à la capacité répartie de la ligne. En ce qui concerne la voie à basse fréquence, il est nécessaire que le dispositif de séparation, qui réalise à la fois un filtrage et une égalisation, présente une impédance d'entrée et une impédance de sortie qui soient les plus voisines possibles de l'impédance caractéristique de la ligne, ou qui, pour des raisons liées à l'utilisation de transformateurs hybrides, soient les plus proches possibles d'une impédance normalisée définie par les différentes administrations spécialisées (telles France Télécom, Deutsche Telekom, etc.). Dans la suite de ce document, on entendra par impédance caractéristique, l'impédance complexe normalisée définie par ces administrations spécialisées.

Par ailleurs, le dispositif de filtrage et d'égalisation de la voie à basse fréquence ne doit pas perturber le service téléphonique, c'est-à-dire qu'il ne doit pas introduire dans la voie à basse fréquence de signaux pouvant affecter la qualité des signaux vocaux de la conversation téléphonique. De même, la voie téléphonique ne doit pas induire dans la voie de données des signaux perturbateurs créés, par exemple, par les manoeuvres de décrochage et de raccrochage du combiné téléphonique ou par la sonnerie qui est transmise sur la ligne.

Les impédances caractéristiques des lignes téléphoniques peuvent varier d'un pays à un autre. C'est ainsi que l'impédance caractéristique des lignes téléphoniques allemandes est différente de celle des lignes utilisées en France et dans d'autres pays d'Europe. Le filtre à aiguillage doit donc pouvoir être facilement adapté aux différents types de lignes téléphoniques.

Et en outre, d'une manière générale, il est souhaitable que le filtre d'aiguillage soit facile à installer chez l'abonné et qu'il présente une durée de vie suffisamment longue, par exemple au moins 10 ans.

A l'effet de satisfaire au mieux à ces diverses exigences, l'invention a pour objet un filtre à aiguillage pour la séparation d'une voie de données numériques modulées à haute fréquence et d'une voie de signaux analogiques téléphoniques à basse fréquence, lesdites données et lesdits signaux étant transmis simultanément sur une boucle d'abonné comportant une ligne téléphonique bifilaire présentant une impédance caractéristique complexe, dans lequel la voie à basse fréquence comprend un égaliseur passif de sortie comportant une résistance et une inductance en parallèle, favorisant l'adaptation d'impédance à l'impédance caractéristique, et un égaliseur actif branché en amont, compensant les pertes résistives de l'égaliseur passif, de manière à transmettre, avec de faibles pertes et sous l'impédance caractéristique, les signaux téléphoniques entre la ligne téléphonique et le central téléphonique ou le poste d'abonné, sans induire de signaux parasites dans la ligne.

Selon un mode de réalisation de l'invention, la voie à basse fréquence comporte, en série, un premier filtre simple passe-bas dont l'impédance d'entrée est adaptée à l'impédance caractéristique et qui bloque le passage de signaux à haute fréquence, le premier égaliseur actif, un deuxième filtre, calculé pour assurer une bonne réjection en bande coupée et rejetant le bruit induit par le premier égaliseur actif, et le deuxième égaliseur passif.

Avantageusement, le premier filtre, à savoir le filtre passe-bas, est un filtre en échelle qui, suivant le mode de réalisation que l'on choisira dans chaque application particulière, sera actif ou passif. Il pourra notamment avoir une topologie semblable à celle d'un filtre elliptique, ou bien une topologie semblable à celle d'un filtre ayant tous ses pôles d'affaiblissement à l'infini (c'est-à-dire semblable à la topologie d'un filtre de Butterworth ou de Tchebychev).

Selon un mode de réalisation de l'invention, le deuxième filtre comporte au moins un filtre passif qui possède la même topologie qu'un filtre elliptique passe-bas. Selon un autre mode de réalisation, le deuxième filtre pourra être réalisé suivant la topologie d'un filtre ayant tous ses pôles à l'infini (topologie d'un filtre de Butterworth ou de Tchebychev notamment). Avantageusement et quelle que soit sa topologie, le deuxième filtre pourra être réalisé en technologie active.

Selon une autre caractéristique de l'invention, le premier égaliseur simule la mise en série d'une résistance et d'une capacité toutes les deux négatives. Avantageusement, il comporte au moins un amplificateur opérationnel comportant une charge comportant une résistance et un condensateur en série. Dans ses modes de réalisation préférés, il comporte un transformateur.

Pour l'utilisation sur des lignes téléphoniques usuelles, les filtres et les égaliseurs ont une structure symétrique. En ce qui concerne le premier égaliseur actif, on utilise avantageusement des amplificateurs opérationnels dont le montage permet la réalisation d'un convertisseur d'impédance négative.

Selon encore une autre caractéristique de l'invention, concernant les modes de réalisation les plus utiles dans la pratique industrielle, les éléments actifs sont à alimentation interne.

L'invention sera maintenant plus complètement décrite dans le cadre de caractéristiques préférées et de leurs avantages, en faisant référence aux figures des dessins annexés qui les illustrent et dans lesquelles :

- la figure 1 représente, de manière schématique, un système de transmission simultanée de conversations téléphoniques et de données sur une boucle d'abonné ;

- la figure 2 est une représentation schématique de la voie à basse fréquence du filtre à aiguillage de la figure 1 du côté abonné ;

- la figure 3 représente l'impédance caractéristique de la ligne sous la forme d'une impédance de référence de type Darlington ;

- la figure 4 est une représentation schématique d'un mode de réalisation de la voie à basse fréquence ;

- la figure 5 est le schéma d'un mode de réalisation de l'égaliseur actif utilisant un amplificateur opérationnel ;

- la figure 6 est le schéma d'un égaliseur actif comportant un transformateur ;

- la figure 7 est le schéma de la réalisation en montage symétrique de l'égaliseur actif de la figure 5 ;

- la figure 9 est la courbe de perte d'insertion de l'ensemble de la voie à basse fréquence ;

- la figure 10 est la courbe des pertes dans la bande passante du filtre égaliseur passe-bas ;

- et la figure 11 est la courbe des pertes par réflexion ("return loss" en anglais) dans la bande passante du filtre égaliseur passe-bas.

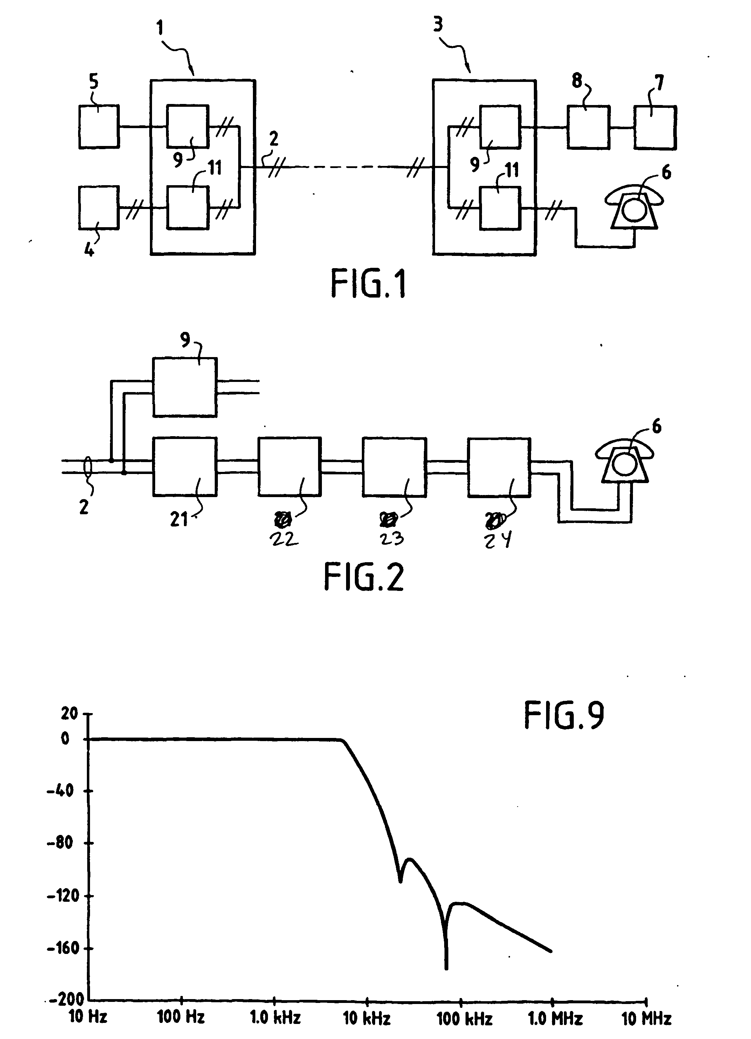

On voit sur la figure 1 une boucle d'abonné appartenant à un réseau téléphonique usuel, qui comporte un central téléphonique 1, relié par une ligne bifilaire 2 à un abonné 3.

La ligne téléphonique 2 est de type usuel ; elle est constituée de deux fils en cuivre entourés d'une gaine en polyéthylène, ces deux fils étant torsadés l'un sur l'autre. Du côté du central 1, on injecte sur la ligne 2, d'une part des signaux analogiques téléphoniques à basse fréquence provenant du central proprement dit 4 et, d'autre part, des données numériques à fréquence élevée provenant d'un réseau d'échange de données 5, par exemple le réseau Internet.

Du côté de l'abonné, on dispose d'un poste téléphonique classique 6 et d'une unité de traitement de données 7, représentée par exemple un ordinateur personnel ou PC (pour "personal computer" en anglais) qui reçoit les données numériques par l'intermédiaire d'un modem 8.

Les signaux téléphoniques analogiques et les données numériques modulées en analogique circulent simultanément sur la ligne 2. On prévoit à cet effet, de chaque côté de la boucle d'abonné, un répartiteur qui comprend, d'une part, une voie haute fréquence 9 qui envoie les données numériques sur le réseau de transmission de données 5 et, d'autre part, une voie à basse fréquence 11 qui filtre les signaux analogiques téléphoniques à basse fréquence.

La circulation des signaux téléphoniques et des données sur la ligne 2 s'effectuant dans les deux sens, les deux répartiteurs ont des fonctions et des structures identiques.

La voie à haute fréquence de données numériques 9 est facile à réaliser ; elle comporte essentiellement un filtre passe-haut et un dispositif de multiplexage et de démultiplexage à répartition de fréquence. En effet, la bande passante de la ligne 2 est partagée en une bande passante à basse fréquence, correspondant à des fréquences inférieures à environ 3,4 kHz, pour les signaux téléphoniques analogiques, et de deux bandes à haute fréquence, une première de 30 à 130 kHz qui constitue un canal à bas débit pour le flux de donnés transmis à partir du poste de l'abonné, et une bande de 130 kHz à 1, 1 MHz qui constitue un canal à haut débit pour le flux des données reçu par l'abonné. Il est à noter ici que lés valeurs indiquées sont celles de France Télécom et qu'elles peuvent varier pour des pays autres que la France. Les deux bandes passantes pour respectivement les données numériques et les deux canaux à bas débit et haut débit, sont adjacentes et séparées grâce au multiplexage à répartition de fréquence propre aux modems de type ADSL.

Par contre, la voie à basse fréquence 11 pose de nombreux problèmes.

Tout d'abord, l'impédance d'entrée, c'est-à-dire l'impédance du côté de la ligne 2, et l'impédance de sortie, c'est-à-dire l'impédance du côté du combiné téléphonique 6, doivent être à la valeur la plus proche possible de l'impédance caractéristique de la ligne 2. Cette impédance est complexe, puisqu'elle comprend une partie capacitive, et elle varie donc en fonction de la fréquence des signaux transmis.

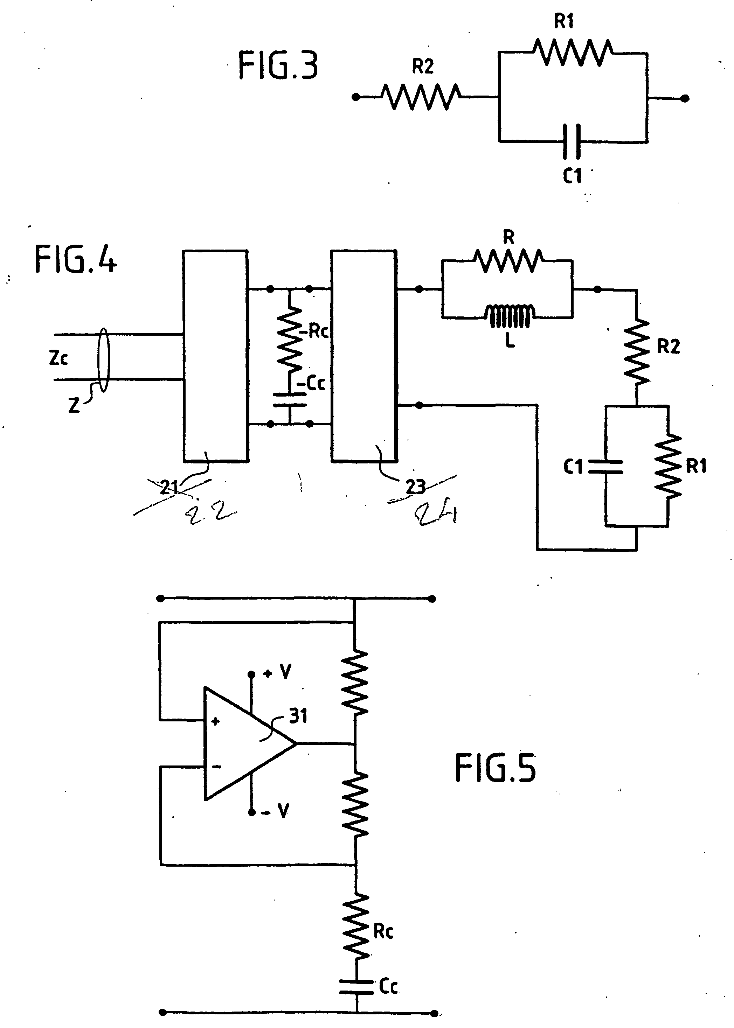

Cette impédance caractéristique est modélisée sous la forme représentée à la figure 3. Elle comporte en série une résistance $R_2$ et l'ensemble d'un condensateur $C_1$ et d'une résistance $R_1$ branchés en parallèle. Les valeurs de l'impédance caractéristique des lignes téléphoniques varient suivant les pays. C'est ainsi que pour la France, les résistances $R_1$ et $R_2$ et le condensateur $C_1$ ont les valeurs suivantes : 750 ohms, 270 ohms et 150 nanofarads. Par contre, ces valeurs sont nettement différentes pour l'Allemagne, où elles valent respectivement 820 ohms, 220 ohms et 115 nanofarads.

Cela crée donc une contrainte supplémentaire pour la voie à basse fréquence 11, qui doit pouvoir être adaptée facilement à l'impédance caractéristique des lignes téléphoniques du pays où le répartiteur est installé.

On a représenté sur la figure 2, de manière schématique, un mode de réalisation de cette voie basse fréquence. La description en est faite pour la voie basse fréquence du répartiteur destiné à être installé chez l'abonné, mais il est évident que la structure de la voie basse fréquence relevant du répartiteur installé au central téléphonique est similaire, puisque les signaux téléphoniques analogiques et les données numériques modulées à haute fréquence circulent sur la ligne 2 dans les deux sens.

A partir de la ligne 2 en direction du combiné téléphonique 6, on trouve successivement un premier filtre passe-bas 21, qui est suivi d'un premier égaliseur actif 22, d'un deuxième filtre 23 et d'un deuxième égaliseur passif 24.

La figure 4 reprend pour partie le contenu de la figure 2, dont elle représente les égaliseurs de manière schématique.

Le second égaliseur ou correcteur 24 doit avoir une impédance de sortie qui soit adaptée à l'impédance caractéristique de la ligne telle qu'elle est schématisée sur la figure 3. Ceci est réalisé en se basant sur une règle selon laquelle on décompose l'ensemble des deux composantes résistives $R_1$ et $R_2$ de l'impédance de référence de la figure 2 comme étant l'impédance de la caractéristique $Z_C$ plus une impédance résiduelle. Il est alors évident que la structure de l'égaliseur 24 est celle d'une inductance L en parallèle sur une résistance R. Les valeurs de l'inductance L et de la résistance R satisfont aux équations suivantes :

$$L = R_1{}^2\, C_1$$

et

$$R = R_1$$

Cet égaliseur passif comporte une résistance R qui dissipe une certaine quantité d'énergie. C'est pourquoi on réinjecte de l'énergie sur la voie à basse fréquence au moyen du premier égaliseur. Ce dernier est alors un égaliseur actif, qui est réalisé par la mise en série d'une capacité et d'une résistance toutes deux négatives, ce qui est schématisé sous la forme d'une résistance négative $-R_C$ et d'une capacité négative $-C_C$.

Ceci est obtenu en décomposant l'ensemble des résistances $R_1$ et $R_2$ de l'impédance de référence avec l'impédance caractéristique en parallèle avec une impédance résiduelle. Les valeurs de la résistance $R_C$ et de la capacité $C_C$ sont conformes aux conditions suivantes :

$$R_C = - (R_1 + R_2)\, {}^* (R_2/R_1)$$

$$C_C = - R_1{}^2\, {}^* C_1 \, / \, (R_1 + R_2)^2$$

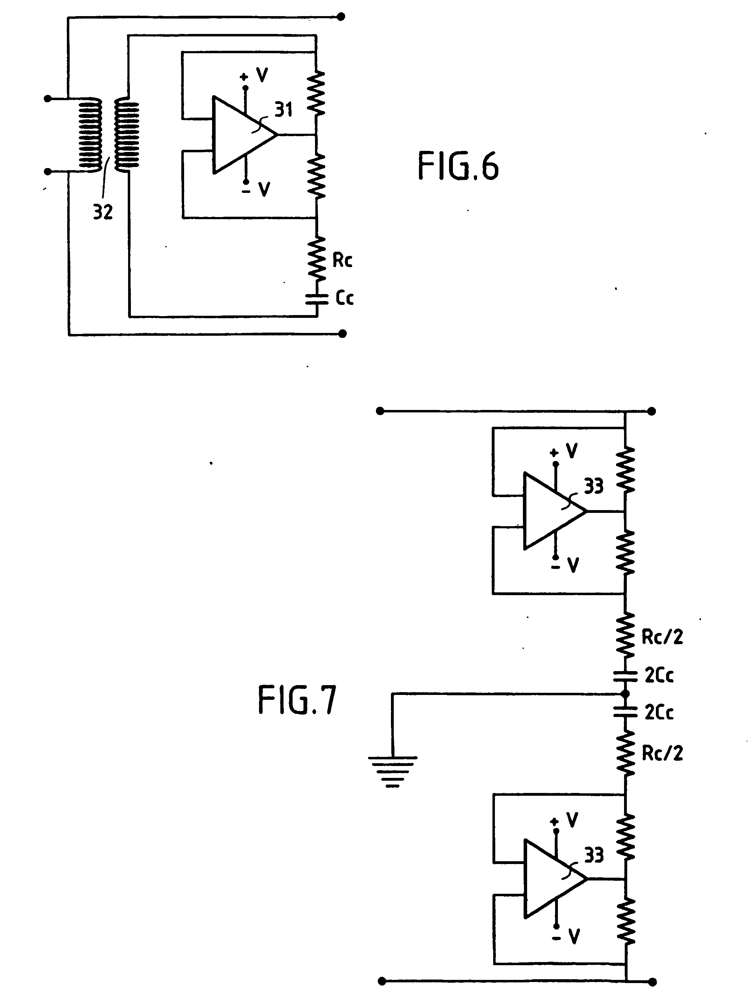

La figure 5 détaille un mode de réalisation des composants négatifs de l'égaliseur 22. Elle montre que l'on utilise essentiellement un amplificateur opérationnel 31 débitant dans une charge constituée par une résistance $R_C$ et un condensateur $C_C$ disposés en série.

Dans le cas où un courant continu important circule dans les circuits de la voie à basse fréquence, et où la tension continue aux bornes du circuit de la figure 5 est supérieure à la tension continue d'alimentation de l'amplificateur opérationnel, il est prévu d'introduire un transformateur 32 à l'entrée de l'égaliseur 22, comme cela est représenté sur la figure 6.

Dans de nombreux cas, où il est notamment nécessaire de symétriser les différents circuits par rapport à la masse, on est amené à réaliser le circuit de la figure 5 sous une forme symétrique comme représentée sur la figure 7. On utilise alors deux amplificateurs opérationnels 33, qui débitent chacun sur une charge constituée par une résistance dont la valeur est $R_C/2$ et d'un condensateur dont la capacité vaut $2C_C$.

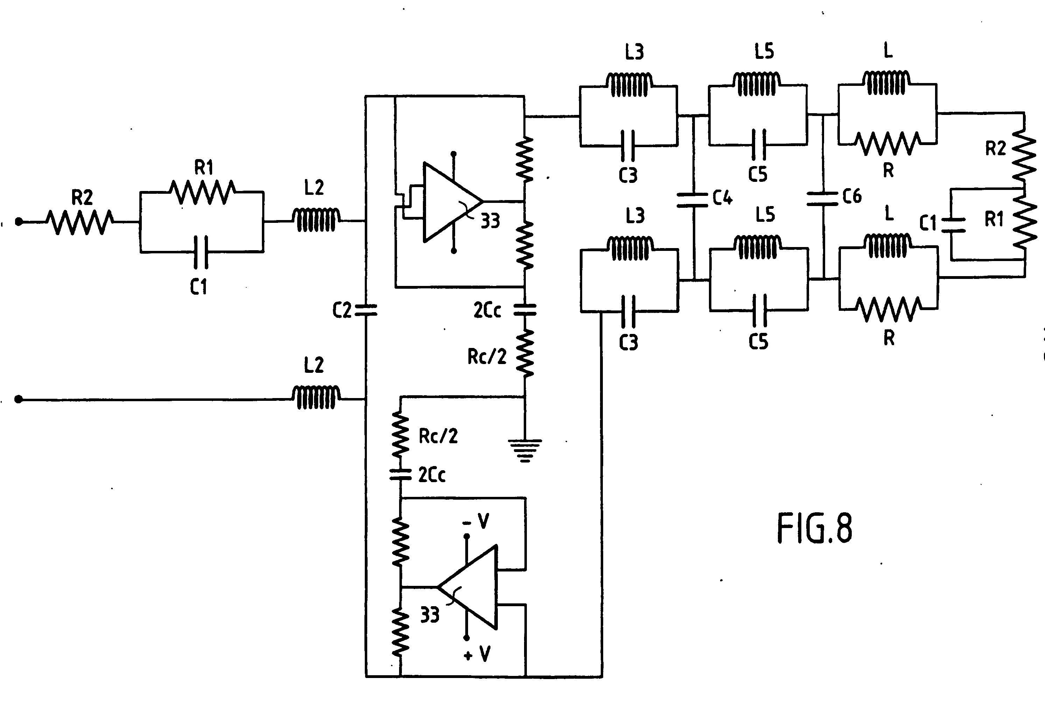

La figure 8 est un schéma détaillé de réalisation de la voie à basse fréquence. La ligne est schématisée par l'impédance de référence de la figure 3.

On voit que le premier filtre est un filtre passif passe-bas de structure simple, à savoir un filtre en échelle comportant une inductance série L2 et un condensateur en parallèle C2. Ce filtre passe-bas a été réalisé sous forme symétrique. Sa fréquence de coupure est d'environ 10 kHz dans le cas particulier présenté (impédance normalisée France Télécom).

L'égaliseur 22 a la structure représentée sur la figure 7. Le deuxième filtre 23 est un filtre passif passe-bas de structure similaire à celle d'un filtre elliptique. Ce deuxième filtre est de structure symétrique. Il comporte deux cellules elliptiques en série, constituées chacune d'un élément série constitué par une inductance L3, respectivement L5, en parallèle sur un condensateur C3, respectivement C5, et d'une capacité de translation parallèle C4, respectivement C6.

Le deuxième égaliseur passif 24 correspond à la structure de la figure 4 symétrisée. L'ensemble de la voie à basse fréquence débite sur le poste téléphonique qui est schématisé sous la forme de l'impédance de référence de la figure 3.

Les valeurs des différents composants des filtres et des égaliseurs sont optimisées en partant des valeurs des éléments des deux égaliseurs 22 et 24 en se basant sur le fait que la puissance injectée par le correcteur actif 22 n'est pas exactement adaptée à la puissance consommée dans le correcteur 24. A cet effet, on utilise un algorithme d'optimisation à référence stochastique (algorithme RSE). Cet algorithme consiste à définir les différents composants de manière récursive par approximations successives pour parvenir à une convergence. Cet algorithme a été perfectionné et adapté à l'optimisation des filtres à aiguillage.

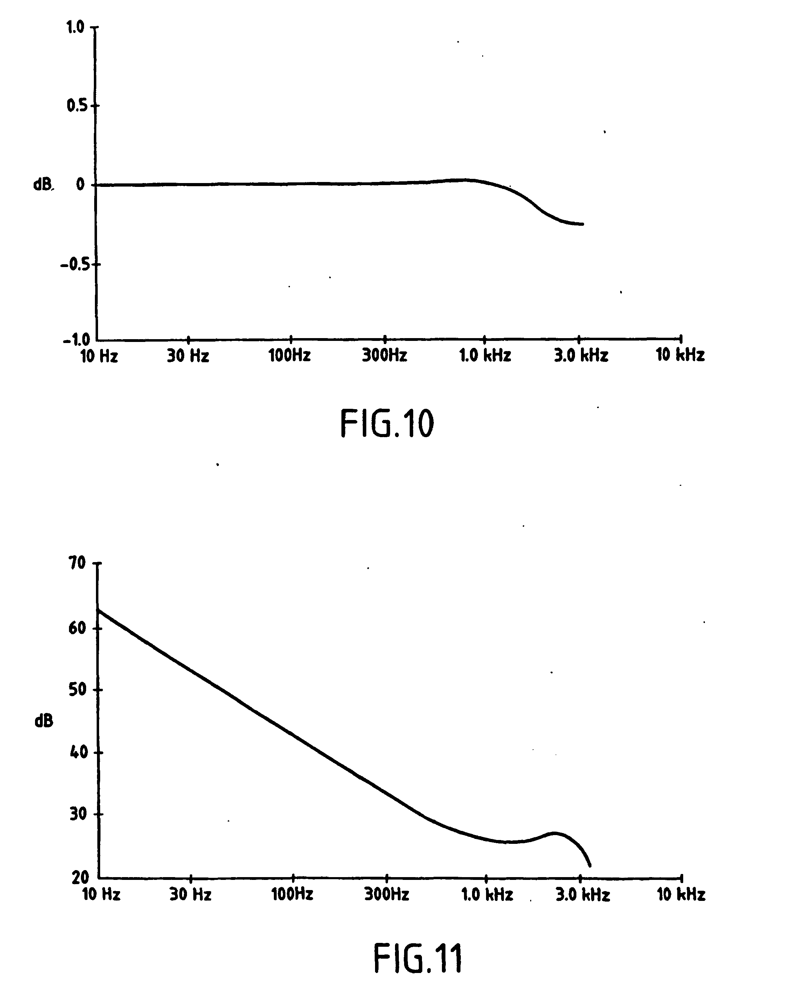

Lorsque tous les composants des circuits 21 à 24 de la figure 8 ont été déterminés par cet algorithme, on a obtenu un filtre à aiguillage ou répartiteur dont la voie à basse fréquence présente les caractéristiques représentées sur les figures 9 à 11.

Pour adapter le filtre à aiguillage selon l'invention à un réseau téléphonique dont l'impédance caractéristique est différente, on utilise toujours l'impédance de référence de type Darlington pour le calcul des égaliseurs, et on calcule aisément les valeurs de départ (avant optimisation) des différents composants, en appliquant en particulier une règle de trois.

On voit sur la figure 9 que la courbe de réponse est pratiquement linéaire pour la bande passante nécessaire pour les signaux analogiques téléphoniques qui respectent en particulier la coupure à 75 dB imposée par certaines administrations. Cette bande est limitée à 3,4 kHz et on voit sur la figure 10, qui représente les ondulations en bande passante, que la réponse est très bonne pour cette bande.

La figure 11, qui est la courbe des pertes par réflexion, montre que l'adaptation à l'impédance caractéristique est bonne puisque, toujours pour la bande de fréquence des signaux téléphoniques, cette courbe varie de 62 à 20 dB, ce qui est nettement supérieur au minimum de 14 dB requis par les administrations de réseaux téléphoniques considérées.

On constate ainsi que l'invention permet de réaliser un répartiteur dans lequel il n'y a pas d'interférence entre les voies à basse fréquence et les voies à haute fréquence. Par ailleurs, la voie à basse fréquence est parfaitement adaptée à l'impédance caractéristique de la ligne comme cela est exigé par l'administration. Enfin, la structure de voie à basse fréquence est relativement simple et donc facile à installer, son prix de revient est peu élevé et sa durée de vie sera suffisamment importante.

La structure du répartiteur sur l'invention est telle que les différents circuits actifs peuvent être réalisés avec une alimentation interne, c'est-à-dire sans faire appel à une alimentation extérieure, ce qui permet d'avoir un répartiteur totalement autonome dont le fonctionnement ne dépend pas d'une source d'alimentation extérieure.

Il ressort néanmoins de ce qui précède que l'invention n'est pas limitée aux modes de mise en oeuvre qui ont été spécifiquement décrits dans le courant des exemples ci-dessus et qu'elle s'étend au contraire à toute variante passant par le biais de moyens équivalents.

## Revendications

1.  Filtre à aiguillage pour ligne de transmission d'informations à impédance complexe, comportant des moyens pour assurer la séparation d'une voie de données numériques à haute fréquence et d'une voie de signaux analogiques téléphoniques à basse fréquence, lesdites données et lesdits signaux étant transmis simultanément sur une boucle d'abonné comportant une ligne téléphonique bifilaire (2) présentant une impédance caractéristique complexe, **caractérisé en ce que** la voie à basse fréquence comprend un égaliseur passif de sortie (24) comportant une résistance (R) et une inductance (L) en parallèle, favorisant l'adaptation d'impédance à l'impédance caractéristique, et un égaliseur actif (22) branché en amont, compensant les pertes résistives de l'égaliseur passif (24), de manière à transmettre, avec de faibles pertes et sous l'impédance caractéristique, les signaux téléphoniques entre la ligne téléphonique (2) et le central téléphonique (1) ou le poste d'abonné (3) sans induire de signaux parasites dans ladite ligne (2).

2.  Filtre à aiguillage selon la revendication 1, **caractérisé en ce que** la voie à basse fréquence comporte, en série, un premier filtre simple passe-bas (21) dont l'impédance d'entrée est adaptée à l'impédance caractéristique et qui bloque le passage de signaux à haute fréquence, le premier égaliseur actif (22), un deuxième filtre (23), calculé à la fois pour de bonnes caractéristiques de réjection en bande coupée et pour rejeter le bruit induit par le premier égaliseur actif, et le deuxième égaliseur passif (24).

3.  Filtre à aiguillage selon la revendication 2, **caractérisé en ce que** le premier filtre passe-bas (21) comporte au moins un filtre en échelle (L2, C2).

4.  Filtre à aiguillage selon la revendication 2, **caractérisé en ce que** le deuxième filtre (23) comporte au moins un filtre passif de structure similaire à celle d'un filtre elliptique passe-bas.

5. Filtre à aiguillage selon la revendication 2, **caractérisé en ce que** le deuxième filtre (23) comporte au moins un filtre actif de structure similaire à celle d'un filtre ayant tous ses pôles d'affaiblissement à l'infini.

6. Filtre à aiguillage selon la revendication 4, **caractérisé en ce que** le deuxième filtre (23) comporte au moins deux cellules de type elliptique en cascade.

7. Filtre à aiguillage selon l'une quelconque des revendications 4 à 6, **caractérisé en ce que** le deuxième filtre est réalisé en technologie active.

8. Filtre à aiguillage selon la revendication 1, **caractérisé en ce que** le premier égaliseur (22) constitue un convertisseur d'impédance négative chargé par une résistance ($-R_C$) mise en série avec une capacité ($-C_C$).

9. Filtre à aiguillage selon la revendication 8, **caractérisé en ce que** le premier égaliseur (22) comporte au moins un amplificateur opérationnel (31, 33), comportant une charge constituée par la mise en série d'une capacité ($-C_C$) et d'une résistance ($-R_C$), l'amplificateur opérationnel agissant comme un convertisseur d'impédance négative.

10. Filtre à aiguillage selon la revendication 1, **caractérisé en ce que** le premier égaliseur (22) comporte un transformateur d'impédance.

11. Filtre à aiguillage selon la revendication 2, **caractérisé en ce que** les filtres et les égaliseurs ont une structure symétrique.

12. Filtre à aiguillage selon la revendication 11, **caractérisé en ce que** le premier égaliseur actif (22) comporte au moins un amplificateur opérationnel en montage convertisseur d'impédance négative.

13. Filtre à aiguillage selon l'une quelconque des revendications précédentes, **caractérisé en ce que** les éléments actifs sont à alimentation interne.

**Patentansprüche**

1. Weichenfilter für Leitung zur Informationsübertragung mit komplexer Impedanz, umfassend Mittel zur Trennung eines Hochfrequenzkanals für digitale Daten von einem Niederfrequenzkanal für analoge Telefonsignale, wobei die Daten und die Signale gleichzeitig über eine Teilnehmerschleife übertragen werden, die eine zweiadrige Fernsprechleitung (2) umfasst, welche eine komplexe charakteristische Impedanz aufweist, **dadurch gekennzeichnet, dass** der Niederfrequenzkanal einen passiven Ausgangsentzerrer (24), der einen Widerstand (R) und dazu eine parallel geschaltete Induktivität (L) umfasst, wodurch die Impedanzanpassung an die charakteristische Impedanz begünstigt wird, und einen vorgeschalteten aktiven Entzerrer (22) enthält, der die Dämpfungsverluste des passiven Entzerrers (24) ausgleicht, sodass die Telefonsignale zwischen der Fernsprechleitung (2) und der Fernsprechzentrale (1) oder dem Teilnehmeranschluss (3) mit geringen Verlusten und bei der charakteristischen Impedanz übertragen werden können, ohne in der Leitung (2) Störsignale zu induzieren.

2. Weichenfilter gemäß Anspruch 1, **dadurch gekennzeichnet, dass** der Niederfrequenzkanal, in Serie geschaltet, umfasst:

   - einen ersten einfachen Tiefpassfilter (21), dessen Eingangsimpedanz der charakteristischen Impedanz angepasst ist und der den Durchgang für Hochfrequenzsignale sperrt,

   - den ersten aktiven Entzerrer (22),

   - einen zweiten Filter (23), der gleichzeitig als Bandsperre mit guter Unterdrückungscharakteristik und zur Unterdrückung des durch den ersten aktiven Entzerrer induzierten Rauschens berechnet wurde,

   - und den zweiten passiven Entzerrer (24).

3. Weichenfilter gemäß Anspruch 2, **dadurch gekennzeichnet, dass** der erste Tiefpassfilter (21) mindestens eine Siebkette (L2, C2).. umfasst.

4. Weichenfilter gemäß Anspruch 2, **dadurch gekennzeichnet, dass** der zweite Filter (23) mindestens einen passiven Filter mit einer Struktur umfasst, die mit derjenigen eines elliptischen Tiefpassfilters vergleichbar ist.

5. Weichenfilter gemäß Anspruch 2, **dadurch gekennzeichnet, dass** der zweite Filter (23) mindestens einen aktiven Filter mit einer Struktur umfasst, die mit derjenigen eines Filters vergleichbar ist, dessen Dämpfungspole im Unendlichen liegen.

6. Weichenfilter gemäß Anspruch 4, **dadurch gekennzeichnet, dass** der zweite Filter (23) mindestens zwei Glieder vom elliptischen Typ in Kaskadenanordnung umfasst.

7. Weichenfilter gemäß irgendeinem der Ansprüche 4 bis 6, **dadurch gekennzeichnet, dass** der zweite Filter in Aktivtechnik ausgeführt ist.

8. Weichenfilter gemäß Anspruch 1, **dadurch gekennzeichnet, dass** der erste Entzerrer (22) einen Wandler mit negativer Impedanz bildet, der durch einen mit einer Kapazität (-Cc) in Serie geschalteten Widerstand (-Rc) geladen wird.

9. Weichenfilter gemäß Anspruch 8, **dadurch gekennzeichnet, dass** der erste Entzerrer (22) mindestens einen Operationsverstärker (31, 33) umfasst, der eine durch die Serienschaltung von einer Kapazität (-Cc) und von einem Widerstand (-Rc) gebildete Last umfasst, wobei der Operationsverstärker wie ein Wandler mit negativer Impedanz wirkt.

10. Weichenfilter gemäß Anspruch 1, **dadurch gekennzeichnet, dass** der erste Entzerrer (22) einen Impedanztransformator umfasst.

11. Weichenfilter gemäß Anspruch 2, **dadurch gekennzeichnet, dass** die Filter und die Entzerrer eine symmetrische Struktur aufweisen.

12. Weichenfilter gemäß Anspruch 11, **dadurch gekennzeichnet, dass** der erste aktive Entzerrer (22) mindestens einen Operationsverstärker in Wandlerschaltung mit negativer Impedanz umfasst.

13. Weichenfilter gemäß irgendeinem der vorhergehenden Ansprüche, **dadurch gekennzeichnet, dass** die aktiven Elemente für Eigenspeisung ausgelegt sind.

**Claims**

1. Splitter filter for an information transmission line with complex impedance, having means to provide the separation of a channel for high frequency digital data and a channel for low frequency telephone analogue signals, the said data and the said signals being transmitted simultaneously over a subscriber line consisting of a two-wire telephone line (2) exhibiting a complex characteristic impedance, **characterised in that** the low frequency channel includes a passive output equaliser (24) having a resistance (R) and an inductance (L) in parallel, encouraging impedance matching to the characteristic impedance, and an active equaliser (22) connected upstream, compensating for the resistive losses of the passive equaliser (24), so as to transmit, with low losses and under the characteristic impedance, the telephone signals between the telephone line (2) and the telephone exchange (1) or the subscriber telephone terminal (3) without inducing parasitic signals in the line (2).

2. Splitter filter according to Claim 1, **characterised in that** the low frequency channel includes, in series, a first simple low pass filter (21) the input impedance of which is matched to characteristic impedance and which filter blocks high frequency signals, the first active equaliser (22), a second filter (23) designed both to have good cutoff frequency band rejection characteristics and to reject noise induced by the first active equaliser, and the second passive equaliser (24).

3. Splitter filter according to Claim 2, **characterised in that** the first low pass filter (21) comprises at least one ladder network filter (L2, C2).

4. Splitter filter according to Claim 2, **characterised in that** the second filter (23) comprises at least one passive filter having a structure similar to that of an elliptical low pass filter.

5. Splitter filter according to Claim 2, **characterised in that** the second filter (23) includes at least one active filter having a structure similar to that of a filter with all its attenuation poles at infinity.

6. Splitter filter according to Claim 4, **characterised in that** the second filter (23) includes at least two cascaded elliptical type cells.

7. Splitter filter according to any one of Claims 4 to 6, **characterised in that** the second filter is implemented using active technology.

8. Splitter filter according to Claim 1, **characterised in that** the first equaliser (22) forms a negative impedance converter loaded by a resistance ($-R_c$) placed in series with a capacitance ($-C_c$).

9. Splitter filter according to Claim 8, **characterised in that** the first equaliser (22) includes at least one operational amplifier (31, 33), having a load made up of the series arrangement of a capacitance ($-C_c$) and a resistance ($-R_c$), the operational amplifier acting as a negative impedance converter.

10. Splitter filter according to Claim 1, **characterised in that** the first equaliser (22) includes an impedance transformer.

11. Splitter filter according to Claim 2, **characterised in that** the filters and the equalisers have a symmetric structure.

12. Splitter filter according to Claim 11, **characterised in that** the first active equaliser (22) includes at least one operational amplifier as part of the negative impedance converter circuit.

**EP 1 260 091 B1**

**13.** Splitter filter according to any one of the preceding claims, **characterised in that** the active elements are powered internally.

FIG.1

FIG.2

FIG.9

FIG.3

FIG.4

FIG.5

FIG.6

FIG.7

FIG.8

FIG.10

FIG.11